(19) Europäisches Patentamt
European Patent Office
Office européen des brevets

(11) EP 2 993 629 A1

(12) **EUROPÄISCHE PATENTANMELDUNG**

(43) Veröffentlichungstag:
09.03.2016 Patentblatt 2016/10

(51) Int Cl.:
*G06Q 10/06* (2012.01)          *G06Q 50/06* (2012.01)
*H02J 3/14* (2006.01)          *C21C 5/52* (2006.01)

(21) Anmeldenummer: 14183226.1

(22) Anmeldetag: 02.09.2014

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **Siemens Aktiengesellschaft
80333 München (DE)**

(72) Erfinder:
• **Dittmer, Björn**
  **90461 Nürnberg (DE)**
• **Döbbeler, Arno**
  **91074 Herzogenaurach (DE)**
• **Engels, Ralf**
  **91336 Heroldsbach (DE)**
• **Matschullat, Thomas**
  **90542 Eckental (DE)**
• **Schmid, Otto**
  **91341 Röttenbach (DE)**

(54) **Zuverlässige Prädiktion eines Energieverbrauchs**

(57) Eine Anlage der Grundstoffindustrie weist zumindest einen elektrischen Verbraucher (1,2) von einem Typ 1 auf. Für Verbraucher (1,2) vom Typ 1 sind jeweils mindestens drei Arbeitspunkte (Aij) definiert, denen jeweils ein zu erwartender Leistungsbezug (PEij) aus einem Versorgungsnetz (5) zugeordnet ist. Die Anlage der Grundstoffindustrie kann weiterhin elektrische Verbraucher (3,4) von einem Typ 2 oder 3 aufweisen, für die entweder jeweils exakt zwei Arbeitspunkte (Aij) definiert sind, denen jeweils ein zu erwartender Leistungsbezug (PEij) aus dem Versorgungsnetz (5) zugeordnet ist, oder denen nur ein zu erwartender Leistungsbezug (PEi) aus dem Versorgungsnetz (5) zugeordnet ist. Fahrdiagramme für die Verbraucher (1-3) vom Typ 1/2 - d.h. die Festlegung von deren Arbeitspunkten (Aij) als Funktion der Zeit (t) - werden unter Berücksichtigung technologischer Kriterien beim Betrieb der Anlage der Grundstoffindustrie derart bestimmt und unter Berücksichtigung des tatsächlichen Energiebezugs (EI) kontinuierlich nachgeführt, so dass ein zwischen einem vorbestimmten Anfangszeitpunkt (TI) und einem vorbestimmten Endzeitpunkt (T2) erwarteter Gesamtenergiebezug (E) einen maximal zulässigen Gesamtenergiebezug (Emax) nicht übersteigt.

FIG 1

EP 2 993 629 A1

**Beschreibung**

Die vorliegende Erfindung geht aus von einem Betriebsverfahren für eine Anlage der Grundstoffindustrie, die eine Anzahl elektrischer Verbraucher aufweist, die aus einem Versorgungsnetz gespeist werden,

- wobei mindestens einer der Verbraucher von einem Typ 1 ist und die anderen Verbraucher vom Typ 1, von einem Typ 2 oder von einem Typ 3 sind,
- wobei für Verbraucher vom Typ 1 und vom Typ 2 jeweils eine Anzahl von Arbeitspunkten definiert ist,
- wobei die Anzahl an Arbeitspunkten bei Verbrauchern vom Typ 1 mindestens drei und bei Verbrauchern vom Typ 2 exakt zwei ist,
- wobei Verbrauchern vom Typ 3 eine durchschnittliche erwartete aus dem Versorgungsnetz zu beziehende Leistung zugeordnet ist,
- wobei während zwischen einem vorbestimmten Anfangszeitpunkt und einem vorbestimmten ersten Endzeitpunkt liegender tatsächlicher Zeitpunkte jeweils ein momentan erwarteter Gesamtenergiebezug ermittelt wird,
- wobei der jeweilige momentan erwartete Gesamtenergiebezug sich durch die Summe der von den Verbrauchern vom Anfangszeitpunkt bis zum jeweiligen tatsächlichen Zeitpunkt tatsächlich aus dem Versorgungsnetz bezogenen, aufgrund von Messdaten ermittelten elektrischen Energie und einem für den Zeitraum von dem jeweiligen tatsächlichen Zeitpunkt bis zum ersten Endzeitpunkt erwarteten Restenergiebezug ergibt,
- wobei der jeweilige erwartete Gesamtenergiebezug mit einem maximal zulässigen Gesamtenergiebezug verglichen wird.

Die vorliegende Erfindung geht weiterhin aus von einem Computerprogramm, das Maschinencode umfasst, der von einer Steuereinrichtung für eine Anlage der Grundstoffindustrie abarbeitbar ist, wobei die Abarbeitung des Maschinencodes durch die Steuereinrichtung bewirkt, dass die Steuereinrichtung die Anlage der Grundstoffindustrie gemäß einem derartigen Betriebsverfahren betreibt.

Die vorliegende Erfindung geht weiterhin aus von einer Steuereinrichtung für eine Anlage der Grundstoffindustrie, wobei die Steuereinrichtung mit einem derartigen Computerprogramm programmiert ist, so dass die Steuereinrichtung die Anlage der Grundstoffindustrie gemäß einem derartigen Betriebsverfahren betreibt.

Die vorliegende Erfindung geht weiterhin aus von einer Anlage der Grundstoffindustrie,

- wobei die Anlage der Grundstoffindustrie eine Anzahl elektrischer Verbraucher aufweist, die aus einem Versorgungsnetz gespeist werden,
- wobei die Anlage der Grundstoffindustrie eine derartige Steuereinrichtung aufweist, welche die Anlage der Grundstoffindustrie gemäß einem derartigen Betriebsverfahren betreibt.

Industrielle Großverbraucher elektrischer Energie regeln den Bezug elektrischer Energie mit einem Energieversorgungsunternehmen oftmals über spezielle Verträge. Diese Verträge bestehen oftmals aus zwei Komponenten, welche die Energiekosten des jeweiligen industriellen Großverbrauchers bestimmen. Die eine Komponente eines derartigen Vertrages ist der Preis für die tatsächlich bezogene elektrische Energie pro Abrechnungseinheit. Abrechnungseinheit ist zumeist ein Jahr, beispielsweise ein Kalenderjahr. Die andere Komponente ist der Preis für die Bereitstellung einer maximal beziehbaren elektrischen Energie über einen definierten Zeitraum. Der definierte Zeitraum liegt in der Regel im Bereich von Minuten, beispielsweise zwischen 5 Minuten und einer Stunde, insbesondere zwischen 8 Minuten und 30 Minuten. Typisch ist beispielsweise ein Zeitraum von 15 Minuten. Je höher die bereitzustellende Energie ist, desto höher ist das zu zahlende Entgelt. Bezieht der industrielle Großverbraucher über den definierten Zeitraum mehr als die vereinbarte maximal beziehbare elektrische Energie, so werden Vertragsstrafen fällig. Beispielsweise kann für die gesamte Abrechnungseinheit ein höherer Tarif für jede innerhalb der Abrechnungseinheit verbrauchte Kilowattstunde angesetzt werden. Alternativ oder zusätzlich kann eine Strafzahlung in zuvor festgelegter Höhe fällig werden. Die Betreiber der industriellen Großverbraucher sind daher aus Kostengründen zum einen bestrebt, die vereinbarte maximal beziehbare elektrische Energie für den definierten Zeitraum möglichst niedrig zu wählen und zum anderen diese Energiemenge nicht zu überschreiten. Um ein Überschreiten zu verhindern, kann es sogar geschehen, dass in bestimmten Lastsituationen einzelne Verbraucher selektiv abgeschaltet werden müssen. Dadurch wird der planmäßige Produktionsbetrieb gestört. Die Produktivität sinkt.

Ein Beispiel eines industriellen Großverbrauchers ist ein Elektrostahlwerk. Ein Elektrostahlwerk weist als wesentliche Energieverbraucher einen Lichtbogenofen zum Einschmelzen von Metall, einen Pfannenofen zur nachfolgenden Pufferung und metallurgischen Behandlung und nachgeordnete Aggregate wie beispielsweise eine Stranggießanlage und ein Walzwerk auf. Ferner weist das Elektrostahlwerk "normale" Verbraucher wie beispielsweise Lüfter, Kompressoren, Kühlaggregate, elektrische Beleuchtung usw. auf.

Aus der Firmendruckschrift MAXIMUM DEMAND CONTROL SYSTEMS der Firma Measurlogic Inc., 7334 S. Alton Way, Centennial, CO 80112, USA, aufgefunden am 16.06.2014 unter der Internetadresse http://www.measurlogic.com/EnergyManagement/Resources/ MaxDemandBook loM6.pdf und ausgedruckt am gleichen Tag, ist bekannt, während eines derartigen definierten Zeitraums die bisher verbrauchte Energie zu erfassen. Weiterhin wird anhand der bisher verbrauchten Energie in Verbindung mit einer Vorhersage über den zukünftigen Energieverbrauch abgeschätzt, ob die vereinbarte maximal beziehbare elektrische Energie überschritten wird. Wenn dies der Fall ist, wird eine Bedienperson alarmiert oder werden ausgewählte Verbraucher abgeschaltet. Das Überwachungssystem weist bei diesem System keine Kenntnis über den tatsächlichen Prozesszustand der einzelnen Verbraucher auf.

Aus dem Fachaufsatz "Zukunftsorientiertes Lastmanagement optimiert Energiekosten", Sonderdruck 2011 der Fachzeitschrift Metering automation, ist bekannt, während eines derartigen definierten Zeitraums die bisher verbrauchte Energie zu erfassen und anhand der bisher verbrauchten Energie in Verbindung mit einer Vorhersage über den zukünftigen Energieverbrauch abzuschätzen, ob die vereinbarte maximal beziehbare elektrische Energie überschritten wird. Zusätzlich ist es möglich, prognostizierte Lastkurven festzulegen und vollautomatisch nachzufahren. Der "Fahrplan" wird manuell in das Überwachungssystem eingespielt. Auch bei diesem System weist das Überwachungssystem keine Kenntnis über den tatsächlichen Prozesszustand der einzelnen Verbraucher auf.

Aus dem Fachaufsatz "Prädiktive dynamische Lastkontrolle für ein Elektrostahlwerk" von Vico Haverkamp et al., stahl und eisen 128 (2008), Nummer 10, Seiten 61 bis 68, ist bekannt, anhand der Menge und Art an einzuschmelzendem Material eines Lichtbogenofens abzuschätzen, wie lange der Lichtbogenofen noch in Betrieb sein wird, und in Abhängigkeit davon zu entscheiden, ob die vereinbarte maximal beziehbare elektrische Energie überschritten wird. Wenn dies der Fall ist, wird der Lichtbogenofen in eine niedrigere Betriebsstufe überführt, in welcher er weniger Energie aus dem elektrischen Versorgungsnetz bezieht. Diese Vorgehensweise stellt bereits einen Fortschritt dar, weil in begrenztem Umfang tatsächliche Betriebsparameter der Anlage der Grundstoffindustrie vorausschauend mit berücksichtigt werden.

Die Aufgabe der vorliegenden Erfindung besteht darin, eine besonders zuverlässige Möglichkeit zu schaffen, mittels derer ein technologisch optimierter Betrieb der Anlage der Grundstoffindustrie erzielt werden kann, der die vereinbarte maximal beziehbare elektrische Energie für den definierten Zeitraum nicht überschreitet.

Die Aufgabe wird durch ein Betriebsverfahren mit den Merkmalen des Anspruchs 1 gelöst. Vorteilhafte Ausgestaltungen des Betriebsverfahrens sind Gegenstand der abhängigen Ansprüche 2 bis 10.

Erfindungsgemäß wird ein Betriebsverfahren der eingangs genannten Art dadurch ausgestaltet,

- dass vor dem Anfangszeitpunkt für die Verbraucher vom Typ 1 und Typ 2 unter Berücksichtigung technologischer Kriterien beim Betrieb der Anlage der Grundstoffindustrie jeweils ein Fahrdiagramm bestimmt wird, das innerhalb eines Zeitfensters für jeden Zeitpunkt den jeweiligen Arbeitspunkt des jeweiligen Verbrauchers festlegt,

- dass das Zeitfenster sich zumindest von dem Anfangszeitpunkt zu dem ersten Endzeitpunkt erstreckt,

- dass den Arbeitspunkten jeweils eine für den jeweiligen Arbeitspunkt erwartete aus dem Versorgungsnetz zu beziehende Leistung zugeordnet ist,

- dass die Fahrdiagramme für die Verbraucher vom Typ 1 und Typ 2 derart bestimmt werden, dass zwischen dem Anfangszeitpunkt und dem ersten Endzeitpunkt ein anfänglicher Gesamtenergiebezug erwartet wird, der den maximal zulässigen Gesamtenergiebezug nicht übersteigt,

- dass der jeweilige erwartete Restenergiebezug sich durch die Fahrdiagramme für die Verbraucher vom Typ 1 und Typ 2 vom jeweiligen tatsächlichen Zeitpunkt zum ersten Endzeitpunkt und die durchschnittlichen erwarteten aus dem Versorgungsnetz zu beziehenden Leistungen der Verbraucher vom Typ 3 ergibt,

- dass in dem Fall, dass der jeweilige erwartete Gesamtenergiebezug den maximal zulässigen Gesamtenergiebezug übersteigt, unter Berücksichtigung der technologischen Kriterien beim Betrieb der Anlage der Grundstoffindustrie das Fahrdiagramm für mindestens einen Verbraucher vom Typ 1 oder vom Typ 2 variiert wird und/oder mindestens einer der Verbraucher vom Typ 3 abgeschaltet wird oder ein Einschalten mindestens eines Verbrauchers vom Typ 3 unterdrückt wird, so dass der erwartete Gesamtenergiebezug den maximal zulässigen Gesamtenergiebezug nicht übersteigt.

Es wird also nicht nur passiv das Verhalten der Anlage der Grundstoffindustrie vorhergesagt. Auch wird nicht nur das Verhalten der Anlage der Grundstoffindustrie nachgeführt. Es erfolgt vielmehr die Nachführung zum einen unter Berücksichtigung der technologischen Kriterien beim Betrieb der Anlage der Grundstoffindustrie und zum anderen unter direkter Vorhersage der sich dadurch ergebenden Auswirkungen auf den Energiebezug.

Dadurch wird erreicht, dass insbesondere das elektrische Verbrauchsverhalten der Verbraucher vom Typ 1 und vom Typ 2 mit hoher Genauigkeit vorhergesagt werden kann und dadurch die Fahrdiagramme für diese Verbraucher entsprechend optimiert werden können.

Es ist möglich, dass die anfänglich bestimmten Fahrdiagramme nur dann geändert werden, wenn der jeweilige erwartete Gesamtenergiebezug den maximal zulässigen Gesamtenergiebezug übersteigt. In einer bevorzugten Ausgestaltung wird jedoch der jeweilige erwartete Gesamtenergiebezug nicht nur mit dem maximal zulässigen Energiebezug verglichen, sondern zusätzlich auch mit einem minimalen Gesamtenergiebezug. Dadurch ist es möglich, dass in dem Fall, dass der jeweilige erwartete Gesamtenergiebezug den minimalen Gesamtenergiebezug unterschreitet, unter Berücksichtigung der technologischen Kriterien beim Betrieb der Anlage der Grundstoffindustrie das Fahrdiagramm für mindestens einen Verbraucher vom Typ 1 oder vom Typ 2 derart variiert wird und/oder mindestens einer der Verbraucher vom Typ 3 eingeschaltet wird, so dass der erwartete Gesamtenergiebezug dem maximal zulässigen Gesamtenergiebezug angenähert wird.

Im Ergebnis wird dadurch nicht nur gewährleistet, dass der maximal zulässige Gesamtenergiebezug nicht überschritten wird, sondern zusätzlich auch gewährleistet, dass der maximal zulässige Gesamtenergiebezug zumindest tendenziell so weit wie möglich ausgeschöpft wird.

In der Regel wird zum Zwecke der Einhaltung des maximal zulässigen Gesamtenergiebezugs das Fahrdiagramm eines Verbrauchers vom Typ 1 variiert werden. In manchen Fällen - insbesondere wenn der maximal zulässige Gesamtenergiebezug nur geringfügig überschritten wird - kann es jedoch sinnvoll sein, dass unter Berücksichtigung der technologischen Kriterien beim Betrieb der Anlage der Grundstoffindustrie mindestens einer der Verbraucher vom Typ 3 abgeschaltet wird oder ein Einschalten dieses Verbrauchers vom Typ 3 unterdrückt wird. Beispiele derartiger Verbraucher sind beispielsweise Kompressoren, Kühlaggregate, Lüfter und dergleichen mehr.

Es ist möglich, dass die Fahrdiagramme sich nur bis zum ersten Endzeitpunkt oder geringfügig darüber hinaus erstrecken. In einer besonders bevorzugten Ausgestaltung jedoch ist vorgesehen,

- dass die Fahrdiagramme sich über den ersten Endzeitpunkt hinaus mindestens bis zu einem zweiten Endzeitpunkt erstrecken,
- dass eine zeitliche Differenz zwischen dem zweiten Endzeitpunkt und dem ersten Endzeitpunkt gleich der zeitlichen Differenz zwischen dem ersten Endzeitpunkt und dem Anfangszeitpunkt ist und
- dass im Rahmen der Ermittlung und der Variierung der Fahrdiagramme auch ein weiterer erwarteter Energiebedarf berücksichtigt wird, der auf den Zeitraum zwischen dem ersten Endzeitpunkt und dem zweiten Endzeitpunkt bezogen ist.

Dadurch ist es möglich, die Fahrdiagramme übergreifend über den aktuellen und mindestens den nächsten definierten Zeitraum zu optimieren. Die entsprechende Vorgehensweise ist weiterhin auch auf weitere, auf den nächsten definierten Zeitraum folgende Zeiträume erweiterbar.

Es ist in bestimmten Betriebszuständen der Anlage der Grundstoffindustrie möglich, dass aus übergeordneten Gründen bestimmte Verbraucher vom Typ 1 oder vom Typ 2 zwangsweise weiter betrieben werden müssen. Dies kann auch in dem Fall gelten, dass der jeweilige erwartete Gesamtenergiebezug den maximal zulässigen Gesamtenergiebezug übersteigt. Es kann sich also die Situation ergeben, dass der jeweilige erwartete Gesamtenergiebezug den maximal zulässigen Gesamtenergiebezug übersteigt, jedoch aufgrund der Berücksichtigung der technologischen Kriterien beim Betrieb der Anlage der Grundstoffindustrie ein Variieren des Fahrdiagramms für den mindestens einen Verbraucher vom Typ 1 oder vom Typ 2, so dass der nach dem Variieren des Fahrdiagramms erwartete Gesamtenergiebezug den maximal zulässigen Gesamtenergiebezug nicht übersteigt, nicht möglich ist. Je nach Lage des Einzelfalls ist es also möglich, dass in diesem Fall ein Überschreiten des maximal zulässigen Gesamtenergiebezugs hingenommen werden muss.

Vorzugsweise wird in dem Fall, dass die zwischen dem Anfangszeitpunkt und dem ersten Endzeitpunkt tatsächlich bezogene Energie den maximal zulässigen Gesamtenergiebezug übersteigt, der maximal zulässige Gesamtenergiebezug zumindest für auf den ersten Endzeitpunkt folgende Zeiträume erhöht. Dadurch kann das Überschreiten des zuvor maximal zulässigen Gesamtenergiebezugs zwar nicht mehr rückgängig gemacht werden. In vielen Fällen ist es jedoch, soweit es das an das Energieversorgungsunternehmen zu entrichtende Entgelt betrifft, irrelevant, ob der maximal zulässige Gesamtenergiebezug nur einmal oder mehrmals überschritten wird. In dem Fall, dass der maximal zulässige Gesamtenergiebezug einmal überschritten wurde, kann daher für die nachfolgenden Zeiträume eine Optimierung der Fahrdiagramme für die Verbraucher vom Typ 1 und vom Typ 2 unabhängig davon erfolgen, ob der vorherige maximal zulässige Gesamtenergiebezug erneut überschritten wird oder nicht. Durch diese Vorgehensweise sind unter Umständen unter Gesichtspunkten einer Optimierung des Betriebs der Anlage der Grundstoffindustrie ohne Berücksichtigung der Energiekosten bessere Betriebsweisen ermittelbar.

Es ist möglich, dass die Variierung der Fahrdiagramme unabhängig davon erfolgt, in welchem Betriebszustand die Verbraucher sich momentan befinden. Vorzugsweise jedoch ist den Verbrauchern vom Typ 1 und vom Typ 2 statisch oder dynamisch jeweils eine hohe oder eine niedrige Prioritätsstufe zugeordnet. Dadurch ist es möglich, dass beim Variieren der Fahrdiagramme vorrangig diejenigen Fahrdiagramme variiert werden, welche denjenigen Verbrauchern vom Typ 1 und vom Typ 2 zugeordnet sind, denen momentan eine niedrige Prioritätsstufe zugeordnet ist. Es ist daher möglich, festzulegen, welche Fahrdiagramme vorrangig variiert werden sollen und welche Fahrdiagramme nur dann variiert werden sollen, wenn die Variierung der vorrangig variierten Fahrdiagramme nicht ausreicht. Die entsprechende Vorgehensweise kann weiterhin nach Bedarf auf mehr als zwei Prioritätsstufen erweitert werden.

In einer besonders bevorzugten Ausgestaltung des Betriebsverfahrens werden die von den Verbrauchern vom Typ 1 und vom Typ 2 tatsächlich aus dem Versorgungsnetz bezogenen Leistungen erfasst und werden weiterhin die den Arbeitspunkten zugeordneten erwarteten aus dem Versorgungsnetz zu beziehenden Leistungen anhand der tatsächlich aus dem Versorgungsnetz bezogenen Leistungen nachgeführt. Dadurch ergibt sich im Laufe der Zeit eine immer bessere Vorhersage des erwarteten Gesamtenergiebezugs.

In analoger Weise ist es möglich, dass die von den Verbrauchern vom Typ 3 tatsächlich aus dem Versorgungsnetz bezogenen Leistungen erfasst werden und dass die den Verbrauchern vom Typ 3 zugeordneten erwarteten aus dem Versorgungsnetz zu beziehenden Leistungen anhand der tatsächlich aus dem Versorgungsnetz bezogenen Leistungen nachgeführt werden.

Die Anlage der Grundstoffindustrie kann nach Bedarf ausgebildet sein. Beispielsweise kann die Anlage der Grundstoffindustrie als Elektrostahlwerk ausgebildet sein, die als elektrischen Verbraucher vom Typ 1 einen Lichtbogenofen und/oder einen Pfannenofen aufweist. In diesem Fall sind insbesondere der Lichtbogenofen und/oder der Pfannenofen elektrische Verbraucher vom Typ 1. Weiterhin weisen diese beiden Öfen - also die entsprechenden elektrischen Verbraucher vom Typ 1 - aus dem Versorgungsnetz gespeiste Elektroden auf. Der Arbeitspunkt dieser Verbraucher umfasst vorzugsweise insbesondere eine Höheneinstellung der Elektroden über einem Badspiegel des Lichtbogenofens oder Pfannenofens. Diese Vorgehensweise weist insbesondere den Vorteil auf, dass durch die Höheneinstellung eine gleitende, kontinuierliche Anpassung der aus dem Versorgungsnetz bezogenen Leistung möglich ist. Dies steht im Gegensatz zu beispielsweise einem Umschalten von einer Anzapfung eines den Elektroden vorgeordneten Transformators auf eine andere Anzapfung des Transformators. Ein derartiges Umschalten ist nur stufenweise möglich.

Es ist möglich, dass der maximal zulässige Gesamtenergiebezug eine Konstante ist. Alternativ ist es möglich, dass der maximal zulässige Gesamtenergiebezug in Abhängigkeit von einer Netzauslastung des elektrischen Versorgungsnetzes variiert wird. Weiterhin ist es möglich, den ermittelten erwarteten Energieverbrauch an ein übergeordnetes System zu melden. Dadurch kann das übergeordnete System beispielsweise die nicht benötigte Energie anderweitig nutzen. Alternativ oder zusätzlich kann der maximal zulässige Energiebedarf für spätere Zeiträume angepasst werden.

Die Aufgabe wird weiterhin durch ein Computerprogramm mit den Merkmalen des Anspruchs 10 gelöst. Erfindungsgemäß bewirkt die Abarbeitung des Computerprogramms, dass die Steuereinrichtung die Anlage der Grundstoffindustrie gemäß einem erfindungsgemäßen Betriebsverfahren betreibt.

Die Aufgabe wird weiterhin durch eine Steuereinrichtung für eine Anlage der Grundstoffindustrie mit den Merkmalen des Anspruchs 11 gelöst. Erfindungsgemäß ist die Steuereinrichtung mit einem erfindungsgemäßen Computerprogramm programmiert, so dass die Steuereinrichtung die Anlage der Grundstoffindustrie gemäß einem erfindungsgemäßen Betriebsverfahren betreibt.

Die Aufgabe wird weiterhin durch eine Anlage der Grundstoffindustrie mit den Merkmalen des Anspruchs 12 gelöst. Eine vorteilhafte Ausgestaltung der Anlage der Grundstoffindustrie ist Gegenstand des abhängigen Anspruchs 13.

Erfindungsgemäß ist bei einer Anlage der Grundstoffindustrie der eingangs genannten Art die Steuereinrichtung erfindungsgemäß ausgebildet und betreibt die Anlage der Grundstoffindustrie gemäß einem erfindungsgemäßen Betriebsverfahren.

Die Anlage der Grundstoffindustrie kann insbesondere als Elektrostahlwerk ausgebildet sein und als elektrischen Verbraucher vom Typ 1 einen Lichtbogenofen und/oder einen Pfannenofen aufweisen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:

| FIG 1 | eine Anlage der Grundstoffindustrie, |
|---|---|
| FIG 2 | ein Datenfeld, |
| FIG 3 | eine mögliche Ausgestaltung der Anlage der Grundstoffindustrie von FIG 1, |
| FIG 4 | ein Zeitdiagramm, |
| FIG 5 | ein Ablaufdiagramm, |
| FIG 6 bis 8 | Zeitdiagramme, |
| FIG 9 bis 11 | Ablaufdiagramme, |
| FIG 12 | ein Datenfeld und |
| FIG 13 und 14 | Ablaufdiagramme. |

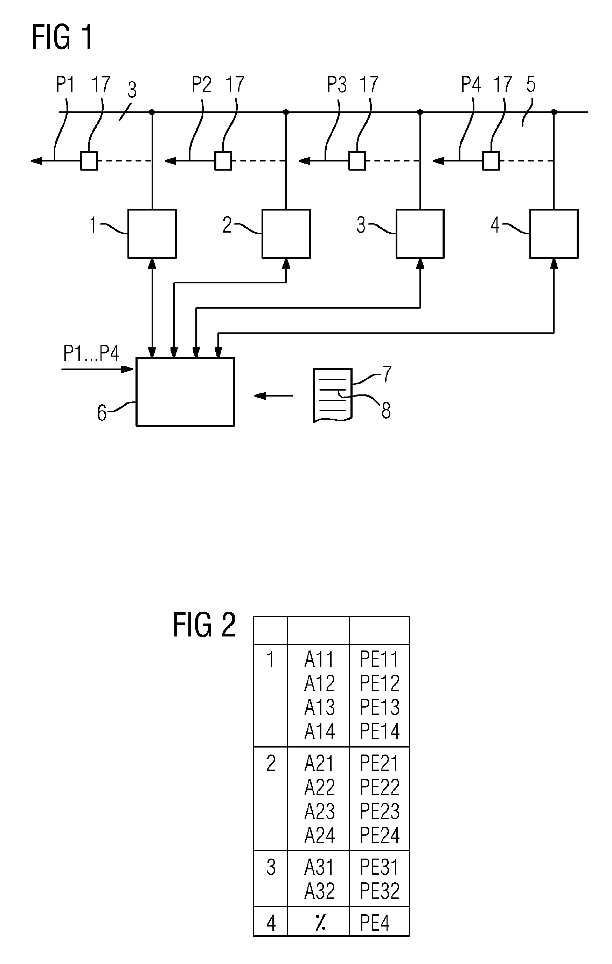

Gemäß FIG 1 weist eine Anlage der Grundstoffindustrie eine Anzahl elektrischer Verbraucher 1 bis 4 auf, die aus einem elektrischen Versorgungsnetz 5 gespeist werden. Dargestellt sind in FIG 1 vier derartige Verbraucher 1 bis 4. Die Anzahl an elektrischen Verbrauchern 1 bis 4 kann jedoch auch (im Einzelfall) kleiner oder (im Regelfall) größer sein.

Unabhängig von der konkreten Ausgestaltung der Anlage der Grundstoffindustrie ist stets ein elektrischer Verbraucher von einem Typ 1 vorhanden. Im vorliegenden Fall ist dies der elektrische Verbraucher 1. Die weiteren Verbraucher 2 bis 4 können nach Bedarf vorhanden sein. Wenn sie vorhanden sind, können sie ebenfalls vom Typ 1 sein. Alternativ können sie von einem Typ 2 oder von einem Typ 3 sein. Im vorliegenden Fall wird angenommen, dass der Verbraucher 2 ebenfalls ein Verbraucher vom Typ 1 ist, dass der Verbraucher 3 ein Verbraucher vom Typ 2 ist und dass der Verbraucher 4 ein Verbraucher vom Typ 3 ist. Es könnte jedoch ebenso eine andere Aufteilung gegeben sein. Auch könnten, wie bereits erwähnt, mehr als diese vier Verbraucher 1 bis 4 vorhanden sein.

Verbraucher 1, 2 vom Typ 1 sind gemäß FIG 2 dadurch gekennzeichnet, dass innerhalb einer Steuereinrichtung 6 für die Anlage der Grundstoffindustrie jeweils eine Anzahl von Arbeitspunkten Aij (i = Index für den jeweiligen Verbraucher, j = Index für den jeweiligen Arbeitspunkt) definiert sind und dass die Anzahl an Arbeitspunkten Aij mindestens drei beträgt. Oftmals ist die Anzahl an Arbeitspunkten Aij für die entsprechenden Verbraucher 1, 2 erheblich größer als 3, beispielsweise größer als 5, größer als 8, größer als 10 usw. Die Anzahl an Arbeitspunkten Aij kann von Verbraucher 1, 2 vom Typ 1 zu Verbraucher 1, 2 vom Typ 1 variieren.

Für jeden Arbeitspunkt Aij sind in der Steuereinrichtung 6 zum einen die entsprechenden Einstellungen des elektrischen Verbrauchers 1, 2 vom Typ 1 hinterlegt, zum anderen eine Leistung PEij. Die Leistung PEij ist derjenige Leistungsbezug aus dem elektrischen Versorgungsnetz 5, der für den jeweiligen Arbeitspunkt Aij des entsprechenden Verbrauchers 1, 2 vom Typ 1 erwartet wird. Die Leistungen PEij können, soweit erforderlich, nach Blind-, Wirk- und/oder Scheinleistung aufgeschlüsselt sein. Die entsprechenden Leistungen PEij sind den jeweiligen Arbeitspunkten Aij also zugeordnet. Mindestens zwei der Arbeitspunkte Aij ist eine korrespondierende erwartete Leistung PEij zugeordnet, die von Null verschieden ist. Es ist möglich, dass die zwei verschiedenen Arbeitspunkten Aij zugeordneten erwarteten Leistungen PEij gleich sind. Wenn dies der Fall ist, ist dies jedoch nicht systembedingt der Fall, sondern rein zufällig. In jedem Fall unterscheiden sich in einem derartigen Fall die Einstellungen dieser Arbeitspunkte Aij des jeweiligen elektrischen Verbrauchers 1, 2 vom Typ 1 voneinander.

Verbraucher 3 vom Typ 2 sind ähnlich charakterisiert wie Verbraucher 1, 2 vom Typ 1. Der entscheidende Unterschied besteht darin, dass die Anzahl von Arbeitspunkten Aij für den jeweiligen Verbraucher 3 vom Typ 2 exakt zwei beträgt. Der Index j kann also nur die Werte 1 und 2 annehmen. Mindestens einem der Arbeitspunkte Aij ist eine korrespondierende erwartete Leistung PEij zugeordnet, die von Null verschieden ist.

Bei Verbrauchern 4 vom Typ 3 ist innerhalb der Steuereinrichtung 6 keine derartige Aufschlüsselung nach Arbeitspunkten hinterlegt. Für Verbraucher 4 vom Typ 3 ist in der Steuereinrichtung 6 lediglich eine durchschnittliche Leistung PEi (i = Index für den jeweiligen Verbraucher) hinterlegt, die von dem entsprechenden Verbraucher 4 im zeitlichen Mittel aus dem Versorgungsnetz 5 bezogen wird.

In der Praxis sind oftmals ausschließlich Verbraucher vom Typ 1 und Verbraucher vom Typ 3 vorhanden, also keine Verbraucher vom Typ 2. Das Vorhandensein von Verbrauchern vom Typ 2 ist jedoch nicht völlig ausgeschlossen.

Die Steuereinrichtung 6 ist gemäß FIG 1 mit einem Computerprogramm 7 programmiert. Das Computerprogramm 7 umfasst Maschinencode 8, der von der Steuereinrichtung 6 abarbeitbar ist. Die Abarbeitung des Maschinencodes 8 durch die Steuereinrichtung 6 bewirkt, dass die Steuereinrichtung 6 die Anlage der Grundstoffindustrie gemäß einem Betriebsverfahren betreibt, das nachfolgend näher erläutert wird.

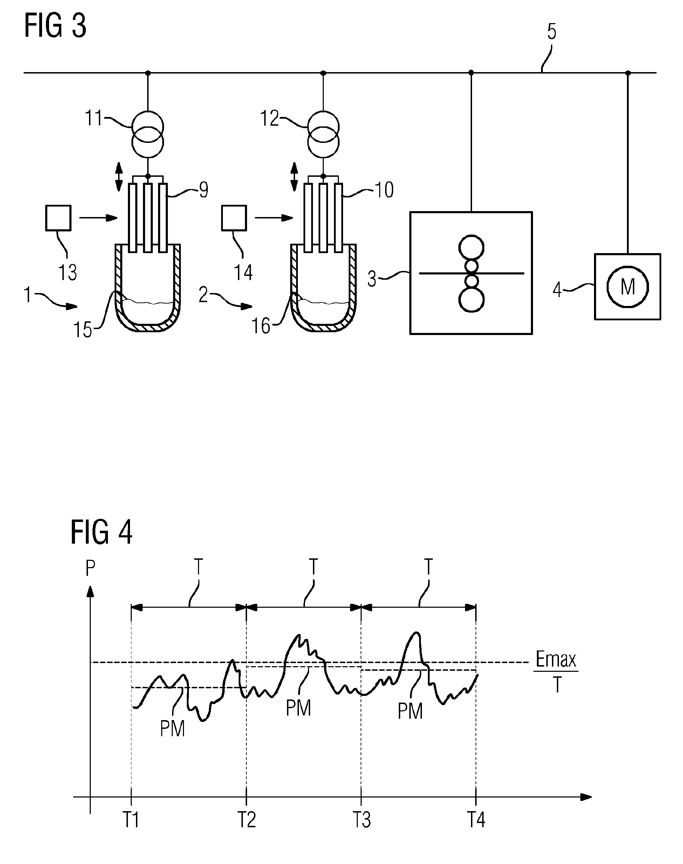

Wie aus FIG 3 ersichtlich ist, kann die Anlage der Grundstoffindustrie beispielsweise als Elektrostahlwerk ausgebildet sein. In diesem Fall können die Verbraucher 1, 2 vom Typ 1 beispielsweise als Lichtbogenofen und/oder als Pfannenofen ausgebildet sein. In der Regel sind beide Verbraucher 1, 2 vorhanden, also sowohl der Lichtbogenofen 1 als auch der Pfannenofen 2. Weitere Verbraucher 3, 4 des Elektrostahlwerks können nach Bedarf als Verbraucher vom Typ 2 oder als Verbraucher vom Typ 3 klassifiziert sein. Beispielsweise kann ein Walzwerk als Verbraucher vom Typ 2 klassifiziert sein. Andere Verbraucher des Elektrostahlwerks - beispielsweise Kompressoren, Kühlaggregate, Pumpen usw. - können als Verbraucher vom Typ 3 klassifiziert sein. Die Öfen 1, 2 sind die Primärverbraucher des Elektrostahlwerks, also diejenigen Verbraucher, welche den weitaus größten Anteil am gesamten Energiebezug des Elektrostahlwerks aus dem Versorgungsnetz 5 haben. Dies gilt ganz besonders für den Lichtbogenofen 1. Weiterhin kann die Leistungsaufnahme der Öfen 1, 2 schnell geregelt werden. Sie eignen sich daher hervorragend als Stellglieder für ein Regelsystem zur Einhaltung eines maximal zulässigen Gesamtenergiebezugs Emax.

Die Öfen 1, 2 weisen Elektroden 9, 10 auf, die - in der Regel über einen jeweiligen Transformator 11, 12 - aus dem Versorgungsnetz 5 gespeist werden. Meist weisen die Transformatoren 11, 12 jeweils mehrere Anzapfungen auf. In diesem Fall umfasst der jeweilige Arbeitspunkt Aij des jeweiligen Ofens 1, 2 insbesondere, über welche Anzapfung die Elektroden 9, 10 aus dem Versorgungsnetz 5 gespeist werden. Gegebenenfalls kann auch eine andere Art der Spannungseinstellung möglich sein. In diesem Fall ist diese Art der Spannungseinstellung Bestandteil des jeweiligen Arbeitspunkts Aij. In der Regel sind weiterhin Verstelleinrichtungen 13, 14 vorhanden, mittels derer eine Höheneinstellung der Elektroden 9, 10 über einem jeweiligen Badspiegel 15, 16 des jeweiligen Ofens 1, 2 erfolgt. Die Arbeitspunkte Aij des jeweiligen Ofens 1, 2 können insbesondere auch direkt oder indirekt diese Höheneinstellung mit umfassen. Beispielsweise können die Arbeitspunkte Aij des jeweiligen Ofens 1, 2 eine Vorgabe für eine Verstell- oder Regeleinrichtung für die Höheneinstellung umfassen. Die Vorgabe kann beispielsweise in Form einer Soll-Impedanz, eines Soll-Stroms oder eines Soll-Widerstands vorgegeben sein. Auch andere Einstellungen sind denkbar. So ist beispielsweise manchen Öfen 1, 2 eine Drossel vorgeschaltet, die primärseitig des jeweiligen Transformators 11, 12 angeordnet ist und mehrere Anzapfungen aufweist. In diesem Fall umfasst der jeweilige Arbeitspunkt Aij auch, welche Anzapfung der jeweiligen Drossel genutzt wird.

Die obigen Ausführungen gelten für Drehstrom-Lichtbogenöfen. Analoge Vorgehensweisen, also insbesondere die Definition verschiedener Arbeitspunkte Aij, sind jedoch auch für andere Öfen möglich, beispielsweise Gleichstrom-Lichtbogenöfen.

Oftmals umfassen die Arbeitspunkte Aij der Öfen 1, 2 weitere Angaben wie beispielsweise die bereits erwähnte Transformatoranzapfung, die verwendete Metall- oder Stahlsorte, die verwendete einzuschmelzende Metallmenge, Tageszeit, Jahreszeit und andere mehr.

Wie aus FIG 4 ersichtlich ist, sind der Steuereinrichtung 6 Zeitpunkte T1, T2, ... bekannt. Die Zeitpunkte T1, T2, ... sind äquidistant. Sie überdecken jeweils einen Zeitraum der Dauer T. Aufgetragen ist in FIG 4 der tatsächliche Leistungsbezug P der Anlage der Grundstoffindustrie aus dem Versorgungsnetz 5. Ersichtlich variiert der Leistungsbezug P als Funktion der Zeit.

Der Leistungsbezug P kann innerhalb gewisser Grenzen durch Variieren des Betriebs der Anlage der Grundstoffindustrie eingestellt werden. Sinn und Zweck der vorliegenden Erfindung ist, die Anlage der Grundstoffindustrie derart zu betreiben, dass in jedem der Zeiträume ein tatsächlicher Energiebezug E1 (also die den jeweiligen Zeitraum bezogene mittlere bezogene Leistung PM, multipliziert mit der Zeitdauer T) einen vereinbarten Gesamtenergiebezug Emax - also den maximal zulässigen Gesamtenergiebezug Emax - nicht übersteigt.

Nachfolgend wird - rein exemplarisch - der Zeitraum zwischen den Zeitpunkten T1 und T2 betrachtet. Die gleiche Vorgehensweise wird jedoch auch bezüglich der anderen Zeiträume ergriffen, also beispielsweise für die durch die Zeitpunkte T2 und T3 oder T4 und T5 begrenzten Zeiträume.

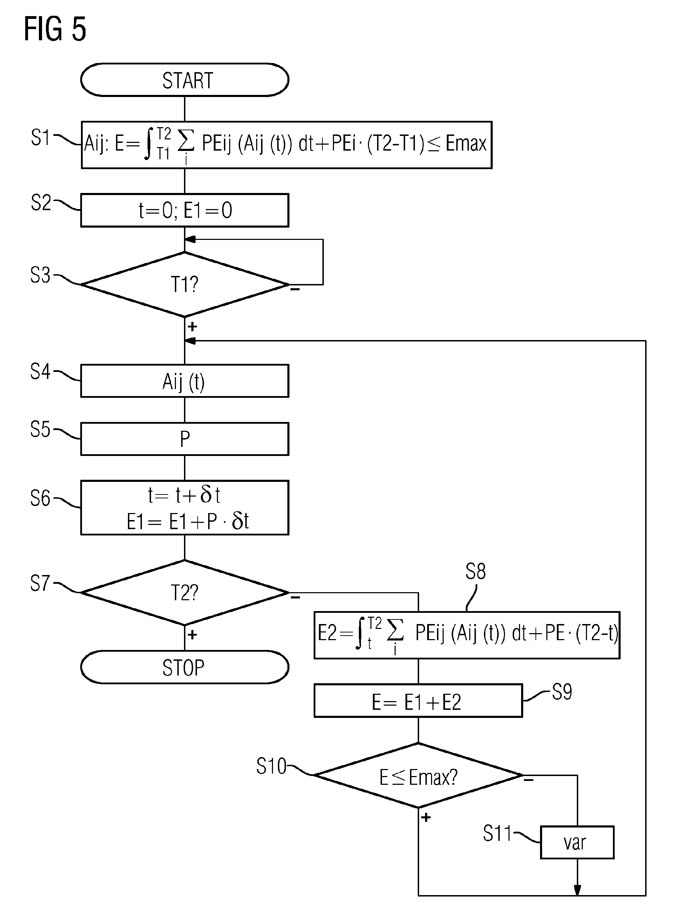

Um zu gewährleisten, dass in dem durch die Zeitpunkte T1 und T2 begrenzten Zeitraum der tatsächliche Energiebezug den maximal zulässigen Gesamtenergiebezug Emax nicht übersteigt, bestimmt die Steuereinrichtung 6 gemäß FIG 5 zunächst in einem Schritt S1 für die Verbraucher 1, 2 vom Typ 1 und - falls vorhanden - die Verbraucher 3 vom Typ 2 jeweils ein Fahrdiagramm. Beispielsweise kann die Steuereinrichtung 6 vordefinierte Fahrdiagramme auswählen oder modifizieren. Die vordefinierten Fahrdiagramme können alternativ in der Steuereinrichtung 6 hinterlegt sein oder in einer anderen Steuereinrichtung hinterlegt sein, auf welche die Steuereinrichtung 6 Zugriff hat.

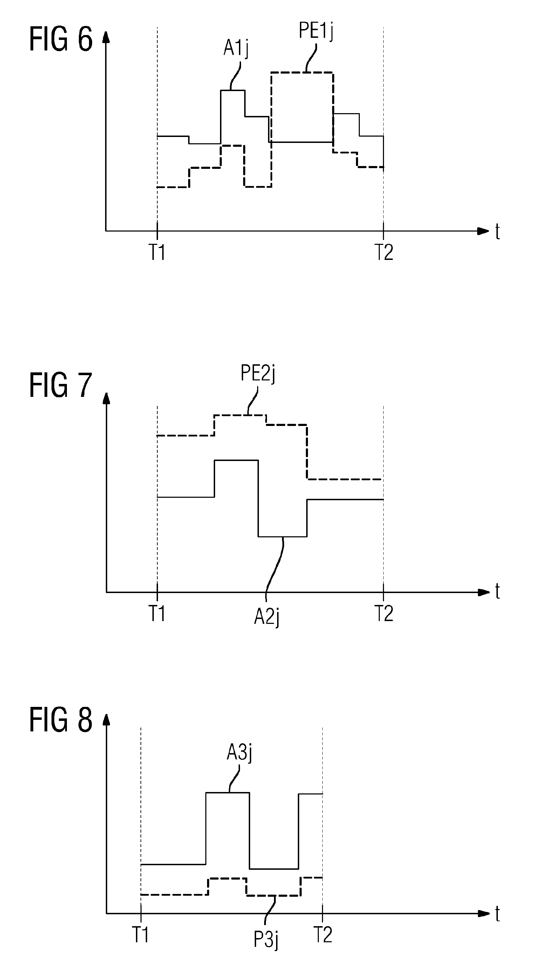

Die Figuren 6 bis 8 zeigen - rein beispielhaft - für die Verbraucher 1 bis 3 mögliche Fahrdiagramme. Die Fahrdiagramme erstrecken sich gemäß den Figuren 6 bis 8 über ein Zeitfenster, das sich seinerseits zumindest von dem Zeitpunkt T1 zum Zeitpunkt T2 erstreckt. Es ist möglich, dass die Fahrdiagramme bereits vor dem Zeitpunkt T1 beginnen und/oder nach dem Zeitpunkt T2 enden. Die Erstreckung über den Zeitraum vom Zeitpunkt T1 zum Zeitpunkt T2 ist also ein Minimalerfordernis. Die Fahrdiagramme umfassen im vorliegenden Fall auch diejenigen Phasen des Betriebs der Verbraucher 1, 2, 3 der Typen 1 und 2, während derer der jeweilige Verbraucher 1, 2, 3 keine Energie aus dem elektrischen Versorgungsnetz 5 bezieht.

Innerhalb des entsprechenden Zeitfensters legt das jeweilige Fahrdiagramm gemäß den Figuren 6 bis 8 für jeden Zeitpunkt t den jeweiligen Arbeitspunkt Aij des jeweiligen Verbrauchers 1, 2, 3 fest. Die Bestimmung der Fahrdiagramme erfolgt im Schritt S1 unter Berücksichtigung technologischer Kriterien beim Betrieb der Anlage der Grundstoffindustrie. Beispielsweise kann ein - an sich bekanntes - regelbasiertes Expertensystem genutzt werden, um die Arbeitspunkte Aij der Verbraucher 1, 2 vom Typ 1 und gegebenenfalls auch des Verbrauchers 3 vom Typ 2 auf prozesstechnisch sinnvolle Weise zu bestimmen. Die Bestimmung der Fahrdiagramme für die Verbraucher 1, 2, 3 vom Typ 1 und Typ 2 erfolgt - selbstverständlich unter Berücksichtigung der technologischen Kriterien beim Betrieb der Anlage der Grundstoffindustrie - entsprechend der Darstellung im Schritt S1 derart, dass ein Gesamtenergiebezug E erwartet wird, der den maximal zulässigen Gesamtenergiebezug Emax nicht übersteigt.

Der Schritt S1 wird vor dem Zeitpunkt T1 ausgeführt. Er ist, soweit es die Bestimmung der Arbeitspunkte Aij als solche betrifft, bekannt. Erfindungsgemäß wird jedoch im Rahmen des Schrittes S1 bereits zu diesem Zeitpunkt der erwartete Gesamtenergiebezug E ermittelt, wie er sich anhand der Fahrdiagramme und der damit verbundenen Leistungen PEij der Verbraucher 1, 2, 3 vom Typ 1 und 2 sowie der durchschnittlichen Leistungen PEi der Verbraucher 4 vom Typ 3 ergibt.

In einem Schritt S2 setzt die Steuereinrichtung 6 sodann den Zeitpunkt t und einen tatsächlichen Energiebezug E1 jeweils auf den Wert 0. Weiterhin wartet die Steuereinrichtung 6 in einem Schritt S3 ab, dass der Zeitpunkt T1 erreicht wird.

Ab dem Zeitpunkt T1 geht die Steuereinrichtung 6 zu einem Schritt S4 über. Im Schritt S4 steuert die Steuereinrichtung 6 die Anlage der Grundstoffindustrie entsprechend den für den jeweiligen Zeitpunkt gültigen Parametern an. Insbesondere erfolgt eine Ansteuerung der Verbraucher 1, 2, 3 vom Typ 1 und vom Typ 2 gemäß dem durch das jeweilige Fahrdiagramm des entsprechenden Verbrauchers 1, 2, 3 für den jeweiligen Zeitpunkt t festgelegten Arbeitspunkt Aij.

In einem Schritt S5 erfasst die Steuereinrichtung 6 den tatsächlichen Leistungsbezug P aus dem elektrischen Versorgungsnetz 5. Es ist im Rahmen der Vorgehensweise gemäß FIG 5 prinzipiell ausreichend, wenn nur der tatsächliche Leistungsbezug P als solcher erfasst wird. Entscheidend ist, dass der tatsächliche Leistungsbezug P aufgrund von Messdaten ermittelt wird. Es handelt sich also um eine tatsächliche, gemessene Größe, nicht um eine rechnerisch ermittelte Größe. Vorzugsweise wird zwar zumindest für jeden Verbraucher 1, 2, 3 vom Typ 1 und vom Typ 2 separat der jeweilige Leistungsbezug Pi (Index i für den jeweiligen Verbraucher 1, 2, 3 vom Typ 1 bzw. vom Typ 2) erfasst und weiterhin zumindest insgesamt der Leistungsbezug P4 der Verbraucher vom Typ 3 erfasst. Dennoch handelt es sich auch in diesem Fall um eine auf den durch Messung erfassten Leistungen ermittelte Gesamtleistung P. Weiterhin kann, soweit erforderlich, eine Korrektur der erfassten Messwerte vorgenommen werden. Dies kann beispielsweise erforderlich sein, um Leitungsverluste zu kompensieren, die zwischen der Messstelle und der Übergabestelle zum elektrischen Versorgungsnetz 5 auftreten. Auch dies ändert nichts daran, dass es sich um eine auf den durch Messung erfassten Leistungen ermittelte Gesamtleistung P handelt.

In einem Schritt S6 erhöht die Steuereinrichtung 6 den tatsächlichen Zeitpunkt t um eine zeitliche Schrittweite $\delta t$. Weiterhin erhöht die Steuereinrichtung 6 im Schritt S6 den tatsächlichen Energiebezug E1 um den momentanen Energiebezug, wie er sich durch das Produkt des tatsächlichen Leistungsbezug P mit der zeitlichen Schrittweite $\delta t$ ergibt. Die zeitliche Schrittweite $\delta t$ liegt in der Regel im Bereich unterhalb 1 Sekunde, oftmals unterhalb 100 ms.

In einem Schritt S7 prüft die Steuereinrichtung 6, ob der Zeitpunkt T2 erreicht worden ist. Wenn dies der Fall ist, ist das erfindungsgemäße Betriebsverfahren beendet, soweit es den betrachteten Zeitraum betrifft, also den von den Zeitpunkten T1 und T2 begrenzten Zeitraum.

Anderenfalls geht die Steuereinrichtung 6 zu einem Schritt S8 über. Im Schritt S8 ermittelt die Steuereinrichtung 6 einen erwarteten Restenergiebezug E2. Der erwartete Restenergiebezug E2 ergibt sich gemäß dem Schritt S8 durch die Fahrdiagramme für die Verbraucher 1, 2, 3 vom Typ 1 und Typ 2 bzw. die hiermit korrespondierenden erwarteten Leistungen PEij und die durchschnittlichen erwarteten Leistungen PEi der Verbraucher vom Typ 3. Er wird berechnet vom jeweiligen tatsächlichen Zeitpunkt t zum Zeitpunkt T2.

In einem Schritt S9 ermittelt die Steuereinrichtung 6 sodann einen erwarteten Gesamtenergiebezug E. Der erwartete Gesamtenergiebezug E ergibt sich durch die Summe des tatsächlichen Energiebezugs E1 bis zum momentanen Zeitpunkt t und den für diesen Zeitpunkt t erwarteten Restenergiebezug E2.

In einem Schritt S10 vergleicht die Steuereinrichtung 6 den im Schritt S9 ermittelten erwarteten Gesamtenergiebezug E mit dem maximal zulässigen Gesamtenergiebezug Emax. Übersteigt der erwartete Gesamtenergiebezug E den maximal zulässigen Gesamtenergiebezug Emax nicht, geht die Steuereinrichtung 6 zum Schritt S4 zurück. Anderenfalls geht sie zu einem Schritt S11 über. Im Schritt S11 kann die Steuereinrichtung 6 für mindestens einen Verbraucher 1, 2 vom Typ 1 dessen Fahrdiagramm variieren. Falls mindestens ein Verbraucher 3 vom Typ 2 vorhanden ist, kann die Steuereinrichtung 6 im Rahmen des Schrittes S11 alternativ oder zusätzlich das Fahrdiagramm des Verbrauchers 3 variieren. Das Variieren des Fahrdiagramms (bzw. der Fahrdiagramme) erfolgt - analog zum Schritt S1 - unter Berücksichtigung der technologischen Kriterien beim Betrieb der Anlage der Grundstoffindustrie. Das Variieren erfolgt weiterhin derart, dass nach dem Variieren des Fahrdiagramms (bzw. der Fahrdiagramme) der erwartete Gesamtenergiebezug E den maximal zulässigen Gesamtenergiebezug Emax nicht übersteigt. Diese Überprüfung ist im Rahmen der erfindungsgemäßen Vorgehensweise ohne weiteres möglich, weil den einzelnen Arbeitspunkten Aij die entsprechenden Leistungen PEij zugeordnet sind und daher mit der Festlegung der Arbeitspunkte Aij auch die entsprechenden Leistungen PEij bekannt sind. Das Variieren der Arbeitspunkte Aij kann insbesondere eine Änderung von Einschaltzeitpunkten, Ausschaltzeitpunkten, Schaltstufen und dergleichen mehr umfassen.

Zusätzlich zu einem Variieren der Fahrdiagramme - in Ausnahmefällen auch alternativ dazu - ist es weiterhin möglich, dass die Steuereinrichtung 6 unter Berücksichtigung der technologischen Kriterien beim Betrieb der Anlage der Grundstoffindustrie mindestens einen der Verbraucher 4 vom Typ 3 abschaltet oder zumindest ein Einschalten mindestens eines Verbrauchers 4 vom Typ 3 unterdrückt. Auch dadurch kann - beispielsweise dann, wenn der maximal zulässige Gesamtenergiebezug Emax nur geringfügig überschritten wird - erreicht werden, dass der erwartete Gesamtenergiebezug E den maximal zulässigen Gesamtenergiebezug Emax nicht übersteigt. Als Verbraucher 4 vom Typ 3 bieten sich hierfür insbesondere Aggregate an, die systembedingt nur von Zeit zu Zeit in Betrieb genommen werden. Rein beispielhaft seien hierfür Kompressoren für Druckluft, Hydraulikpumpen, Kühlaggregate und dergleichen mehr genannt.

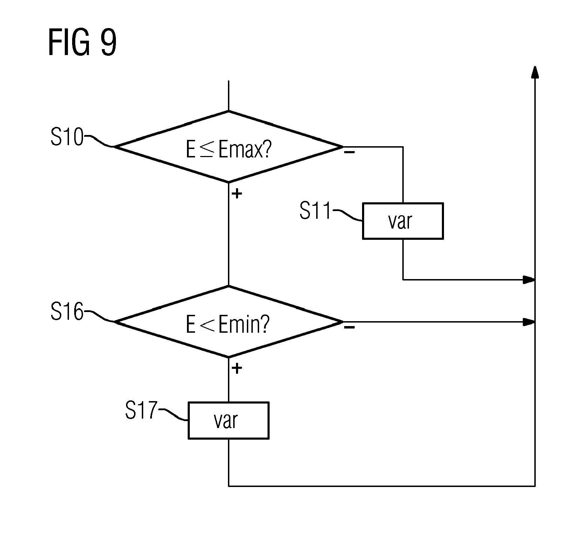

Die Vorgehensweise von FIG 5 kann auf verschiedene Weise ausgestaltet werden. So ist es beispielsweise gemäß FIG 9 möglich, im JA-Zweig des Schrittes S10 zusätzliche Schritte S16 und S17 vorzusehen.

Im Schritt S16 vergleicht die Steuereinrichtung 6 den erwarteten Gesamtenergiebezug E mit einem minimalen Gesamtenergiebezug Emin. Der minimale Gesamtenergiebezug Emin ist (selbstverständlich) kleiner als der maximal zulässige Gesamtenergiebezug Emax. Der minimale Gesamtenergiebezug Emin kann beispielsweise als (relativ hoher) Prozentsatz des maximal zulässigen Gesamtenergiebezugs Emax - beispielsweise einem Wert zwischen 90% und 99% - definiert sein. Alternativ kann der minimale Gesamtenergiebezug Emin oder durch eine (relativ kleine) absolute Differenz zum maximal zulässigen Gesamtenergiebezug Emax definiert sein.

Wenn der erwartete Gesamtenergiebezug E den minimalen Gesamtenergiebezug Emin unterschreitet, geht die Steuereinrichtung 6 zum Schritt S17 über. Im Schritt S17 variiert die Steuereinrichtung 6 - analog zum Schritt S11 von FIG 5 - unter Berücksichtigung der technologischen Kriterien beim Betrieb der Anlage der Grundstoffindustrie das Fahrdiagramm für mindestens einen Verbraucher 1, 2, 3 vom Typ 1 oder vom Typ 2. Auch hier wird - zwar nicht zwangsweise, aber vorzugsweise - das Fahrdiagramm mindestens eines Verbrauchers vom Typ 1 variiert. Alternativ oder zusätzlich kann im Schritt S17 mindestens einer der Verbraucher 4 vom Typ 3 eingeschaltet werden. Ziel des Schrittes S17 ist, dass der nach der Ausführung des Schrittes S17 erwartete Gesamtenergiebezug E dem maximal zulässigen Gesamtenergiebezug Emax angenähert wird.

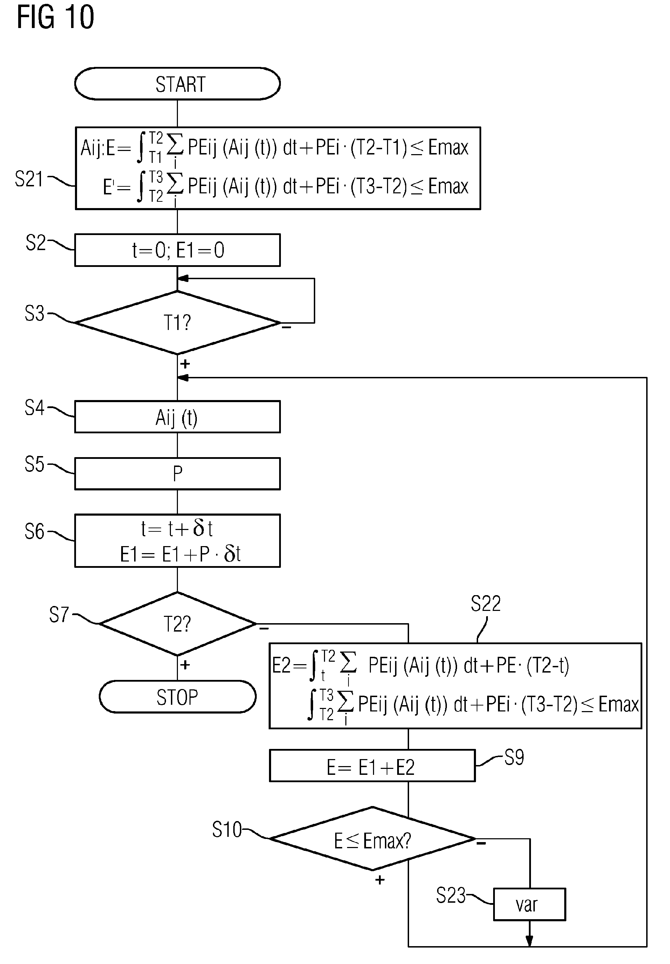

Wie bereits erwähnt, erstrecken sich die Fahrdiagramme zum Zeitpunkt der Ausführung des Schrittes S1 von FIG 5 zumindest vom Zeitpunkt T1 zum Zeitpunkt T2. Es ist jedoch möglich, dass sich die Fahrdiagramme weiter erstrecken, beispielsweise bis zum Zeitpunkt T3, bis zum Zeitpunkt T4 oder sogar noch weiter. In diesem Fall werden also - ähnlich einer prädiktiven Regelung - die Fahrdiagramme nicht nur für eine einzelne Zeitdauer T, sondern für mehrere Zeitdauern T angesetzt. In diesem Fall ist es gemäß FIG 10 möglich, die Schritte S1 und S11 durch Schritte S21 und S22 zu ersetzen.

Im Schritt S21 wird im Rahmen der Ermittlung der Fahrdiagramme der Verbraucher 1, 2 vom Typ 1 und gegebenenfalls auch der Verbraucher 3 vom Typ 2 zum einen - wie bereits in Verbindung mit FIG 5 erläutert - der erwartete Energiebedarf E für den Zeitraum zwischen den Zeitpunkten T1 und T2 ermittelt. Weiterhin wird jedoch in analoger Weise auch ein weiterer erwarteter Energiebedarf E' ermittelt. Dieser Energiebedarf E' ist auf den Zeitraum zwischen den Zeitpunkten T2 und T3 bezogen. In analoger Weise könnten gegebenenfalls auch weitere Energiebedarfe ermittelt werden, die auf noch spätere Zeiträume bezogen sind. Der maximal zulässige Gesamtenergiebezug Emax für den Zeitraum zwischen den Zeitpunkten T2 und T3 ist gemäß FIG 10 gleich dem maximal zulässigen Gesamtenergiebezug Emax für den Zeitraum zwischen den Zeitpunkten T1 und T2. Dies ist jedoch nicht zwingend erforderlich. Alternativ könnte es sich um einen anderen Wert handeln.

Im Rahmen des Schrittes S21 wird bei der Ermittlung der Fahrdiagramme der Verbraucher 1, 2 vom Typ 1 und gegebenenfalls auch der Verbraucher 3 vom Typ 2 für den Zeitraum zwischen den Zeitpunkten T1 und T2 auch berücksichtigt, welche Auswirkungen die für den Zeitraum zwischen den Zeitpunkten T1 und T2 angesetzten Fahrdiagramme aufgrund der zu berücksichtigenden technologischen Kriterien beim Betrieb der Anlage der Grundstoffindustrie auf die Fahrdiagramme der Verbraucher 1, 2, 3 vom Typ 1 und vom Typ 2 für den Zeitraum zwischen den Zeitpunkten T2 und T3 haben. Dadurch können beispielsweise innerhalb gewisser Grenzen Leistungsanforderungen der einzelnen Verbraucher 1, 2, 3 vom Typ 1 und vom Typ 2 zwischen den beiden vom Zeitpunkt T2 begrenzten Zeiträumen (und gegebenenfalls auch weiteren von je zwei der vorbestimmten Zeitpunkte T3, T4, ... begrenzten Zeiträume) hin und her geschoben werden. In völlig analoger Weise wird auch im Schritt S22 vorgegangen.

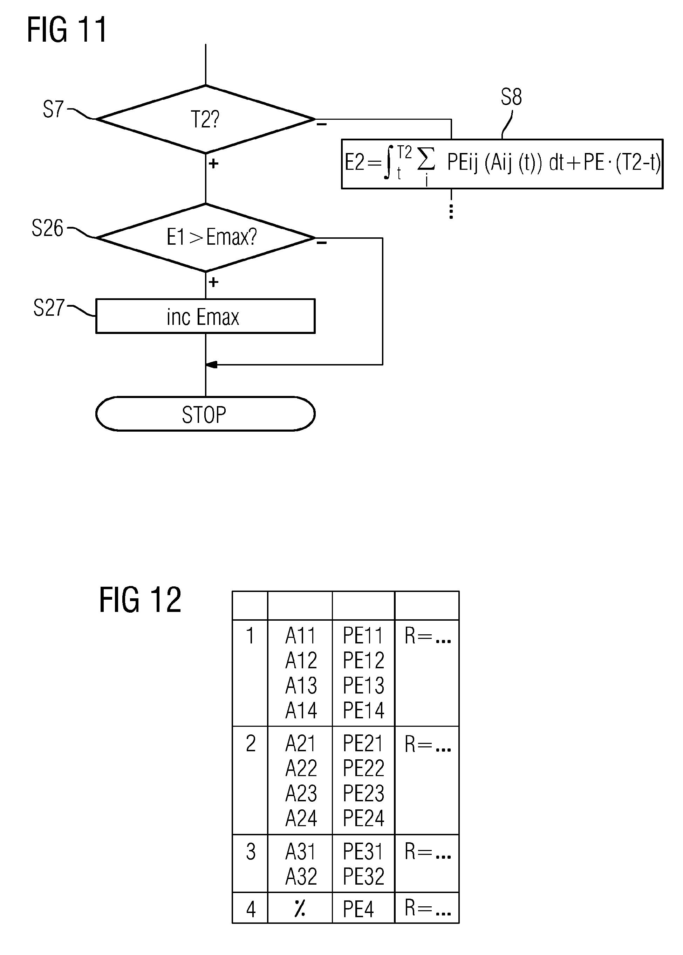

Es ist weiterhin gemäß FIG 11 möglich, im JA-Zweig des Schrittes S7 von FIG 3 zusätzliche Schritte S26 und S27 vorzusehen.

Im Schritt S26 vergleicht die Steuereinrichtung 6 die zwischen den Zeitpunkten T1 und T2 tatsächlich bezogene Energie E1 mit dem maximal zulässigen Gesamtenergiebezug Emax. Insbesondere prüft die Steuereinrichtung 6, ob die tatsächlich bezogene Energie E1 den maximal zulässigen Gesamtenergiebezug Emax übersteigt. Im Regelfall wird dies nicht der Fall sein. In diesem Fall werden keine weiteren Maßnahmen ergriffen.

Es ist jedoch möglich, dass die tatsächlich bezogene Energie E1 den maximal zulässigen Gesamtenergiebezug Emax übersteigt. Ein derartiger Fall kann beispielsweise auftreten, wenn aufgrund übergeordneter technologischer Gegebenheiten eine Reduzierung des Energiebezugs aus dem Versorgungsnetz 5 nicht möglich ist. Beispielsweise hat im Falle eines Elektrostahlwerks die Versorgung einer Stranggießanlage mit flüssigem Metall Vorrang vor der Einhaltung des maximal zulässigen Gesamtenergiebezugs Emax. Wenn also die Gefahr besteht, dass die Stranggießanlage leerläuft, muss einer derartigen Betriebsstörung entgegengewirkt werden und die hiermit verbundene Überschreitung des maximal zulässigen Gesamtenergiebezugs Emax hingenommen werden.

Stellt die Steuereinrichtung 6 im Schritt S26 eine derartige Überschreitung fest, geht sie zum Schritt S27 über. Im Schritt S27 erhöht die Steuereinrichtung 6 den maximal zulässigen Gesamtenergiebezug Emax zumindest für die auf den Zeitpunkt T2 folgenden Zeiträume. Grund für diese Maßnahme kann sein, dass mit dem einmaligen Überschreiten im Zeitraum zwischen den Zeitpunkten T1 und T2 eine Vertragsstrafe fällig geworden ist, deren Höhe jedoch unabhängig davon ist, ob auch in folgenden Zeiträumen - beispielsweise im Zeitraum zwischen den Zeitpunkten T3 und T4 - der für den Zeitraum zwischen den Zeitpunkten T1 und T2 gültige maximal zulässige Gesamtenergiebezug Emax überschritten wird. Dies wird nachfolgend anhand eines Beispiels näher erläutert.

Man nehme an, in einem Zeitraum T von beispielsweise 15 Minuten dürften von der Anlage der Grundstoffindustrie aus dem Versorgungsnetz 5 maximal 25 MWh bezogen werden. Werde dieser Wert überschritten, werde eine Vertragsstrafe von 10.000,00 € fällig. Weiterhin werde die gesamte während des laufenden Monats bezogene Energie mit einem Zuschlag von 100% verrechnet. Eine höhere Vertragsstrafe und/oder ein höherer Tarif würden fällig, wenn ein Wert von 30 MWh überschritten würde.

In einem derartigen Fall wird der maximal zulässige Energiebezug Emax auf einen Wert von 25 MWh gesetzt. Es kann auch ein geringfügig kleinerer Wert angesetzt werden, um einen Sicherheitspuffer zur Verfügung zu haben, beispielsweise 24 MWh. Wenn in einem derartigen Fall am 5. des Monats - egal aus welchen Gründen - in einem der Zeiträume ein tatsächlicher Energiebezug E1 von 25,3 MWh erfolgt, ist die Vertragsstrafe verwirkt und für den gesamten Monat der doppelte Tarif zu zahlen. Dies gilt unabhängig davon, ob in nachfolgenden Zeiträumen bis einschließlich zum Monatsletzten die Grenze von 25 MWh erneut überschritten wird oder nicht. Größere Strafzahlungen würden erst dann wieder fällig, wenn die Grenze von 30 MWh überschritten würde. Es kann daher in einem derartigen Fall der maximal zulässige Energiebezug Emax ohne negative Auswirkungen für den Rest des Monats von 25 MWh auf 30 MWh erhöht werden. Gegebenenfalls kann auch eine Erhöhung auf einen Wert zwischen 25 MWh und 30 MWh erfolgen, beispielsweise 27,5 MWh und 28 MWh, um einen - diesmal größeren - Sicherheitspuffer zur Verfügung zu haben. Weiterhin ist es möglich, diesen höheren Wert bereits im Zeitraum T zwischen den Zeitpunkten T2 und T3 zu berücksichtigen, da er mit Erreichen des Zeitpunkts T2 quasi sofort zur Verfügung steht.

Im Rahmen der erstmaligen Ermittlung der Fahrdiagramme - vergleiche Schritt S1 in FIG 5 - und auch im Rahmen des Variierens der Fahrdiagramme - vergleiche die Schritte S11 in FIG 5 sowie die Schritte S17 und S22 in den Figuren 9 und 10 - werden die Fahrdiagramme auf eine bestimmte Art und Weise festgelegt bzw. variiert. Es ist möglich, dass den Verbrauchern 1, 2 vom Typ 1 (und eventuell auch den Verbrauchern 3 vom Typ 2) entsprechend der Darstellung in FIG 12 Prioritätsstufen R zugeordnet sind. Die jeweilige Prioritätsstufe R kann zumindest einen niedrigen Wert und einen hohen Wert (R = 1 oder R = 2) annehmen. Gegebenenfalls können auch feinere Abstufungen gegeben sein, beispielsweise R = 1 bis R = 4.

In diesem Fall ist es möglich, beim Variieren der Fahrdiagramme vorrangig diejenigen Fahrdiagramme zu variieren, welche denjenigen Verbrauchern 1, 2 vom Typ 1 und gegebenenfalls auch den Verbrauchern 3 vom Typ 2 zugeordnet sind, denen eine niedrige Prioritätsstufe R = 1 zugeordnet ist. Erst wenn es nicht mehr möglich ist, ausschließlich mit Variieren der Fahrdiagramme der Verbraucher 1, 2, 3 einer niedrigen Prioritätsstufe R das gewünschte Ziel - beispielsweise das Einhalten des maximal zulässigen Gesamtenergiebezug Emax zu erreichen, werden zusätzlich Fahrdiagramme von Verbrauchern 1, 2, 3 der hohen bzw. der nächsthöheren Prioritätsstufe R variiert.

Es ist möglich, dass die Prioritätsstufen R den Verbrauchern 1, 2 und gegebenenfalls auch 3 statisch zugeordnet sind. Alternativ kann die Zuordnung der Prioritätsstufen R dynamisch erfolgen. Beispielsweise können im Falle eines Elektrostahlwerks temporär Zustände des Lichtbogenofens 1, des Pfannenofens 2 oder anderer Aggregate - auch eventuell nicht elektrisch betriebene Aggregate - existieren, aufgrund derer ein Variieren eines Fahrdiagramms eines bestimmten elektrischen Verbrauchers 1, 3 - beispielsweise des Pfannenofens 2 - äußerst negative Folgen hätte. In einem derartigen Fall würde dem Pfannenofen 2 temporär die höchste Prioritätsstufe R zugewiesen werden, beispielsweise im Falle von zwei Prioritätsstufen R der Wert R = 2 oder im Falle von vier Prioritätsstufen R der Wert R = 4. Zu einem späteren Zeitpunkt kann in einem derartigen Fall die dem Pfannenofen 2 zugewiesene Prioritätsstufe R wieder auf den Wert R = 1 bzw. im Falle von vier Prioritätsstufen R beispielsweise auf den Wert R = 1 oder den Wert R = 2 gesetzt werden.

Wie bereits erwähnt, ist es im Rahmen des erfindungsgemäßen Betriebsverfahrens prinzipiell ausreichend, den tatsächlichen Leistungsbezug P der Anlage der Grundstoffindustrie in ihrer Gesamtheit messtechnisch zu erfassen. Vorzugsweise sind jedoch gemäß FIG 1 zumindest für die einzelnen Verbraucher 1, 2 vom Typ 1 und - falls vorhanden - auch für die einzelnen Verbraucher 3 vom Typ 2 - jeweilige Messeinrichtungen 17 vorhanden, mittels derer individuell für den jeweiligen Verbraucher 1, 2, 3 dessen Leistungsbezug Pi (i = Index für den jeweiligen Verbraucher 1, 2, 3) erfasst wird. Weiterhin wird entweder der gesamte tatsächliche Leistungsbezug P der Anlage der Grundstoffindustrie in ihrer Gesamtheit oder der verbleibende Leistungsbezug P4 der Verbraucher 4 vom Typ 3 in ihrer Gesamtheit erfasst. Gegebenenfalls können auch für die Verbraucher 4 vom Typ 3 individuell deren tatsächlich bezogene Leistungen erfasst werden.

Da zu jedem Zeitpunkt die Beziehung

$$\sum_i Pi + P4 = P$$

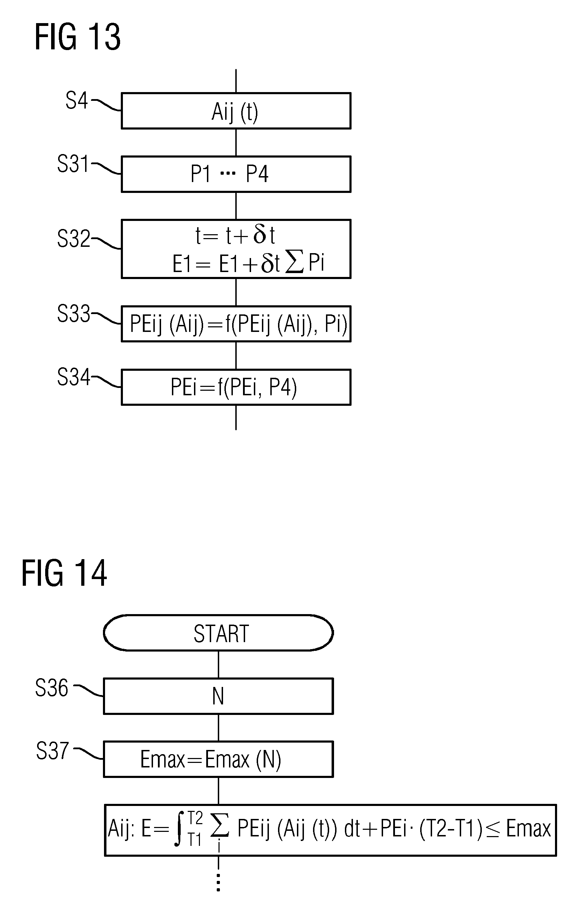

gilt, kann entweder anhand der erfassten Leistungsbezüge Pi der Verbraucher 1, 2, 3 vom Typ 1 und 2 und des verbleibenden Leistungsbezugs P4 der Leistungsbezug P in seiner Gesamtheit ermittelt werden oder anhand der erfassten Leistungsbezüge Pi der Verbraucher 1, 2, 3 vom Typ 1 und 2 und des gesamten Leistungsbezugs P der Anlage der Grundstoffindustrie der verbleibende Leistungsbezug P4 ermittelt werden. In diesem Fall wird die Vorgehensweise von FIG 5 vorzugsweise entsprechend FIG 13 modifiziert.

Gemäß FIG 13 sind die Schritte S5 und S6 von FIG 5 durch Schritte S31 und S32 ersetzt. Weiterhin sind zusätzlich Schritte S33 und S34 vorhanden. Im Schritt S31 erfasst die Steuereinrichtung 6 messtechnisch die tatsächlichen Leistungsbezüge Pi für die Verbraucher 1, 2, 3 vom Typ 1 und vom Typ 2 aus dem Versorgungsnetz 5 und - individuell, in ihrer Gesamtheit oder gruppenweise - den Leistungsbezug P4 für die Verbraucher 4 vom Typ 3 aus dem Versorgungsnetz 5. Im Schritt S32 ermittelt die Steuereinrichtung 6 - analog zum Schritt S6 - den bisherigen tatsächlichen Energiebezug E1. Im Schritt S33 führt die Steuereinrichtung 6 die dem momentanen Arbeitspunkt Aij des jeweiligen Verbrauchers 1, 2, 3 vom Typ 1 bzw. vom Typ 2 zugeordnete erwartete Leistung PEij anhand der jeweiligen tatsächlich aus dem Versorgungsnetz bezogenen Leistung Pi nach. Im Schritt S34 führt die Steuereinrichtung 6 in analoger Weise die den Verbrauchern 4 vom Typ 3 zugeordneten erwarteten Leistungen PEi - je nach Erfassung des Leistungsbezugs P4 - individuell, in ihrer Gesamtheit oder gruppenweise nach.

Es ist möglich, dass der maximal zulässige Gesamtenergiebezug Emax fest vorgegeben ist (zumindest dann, wenn er nicht im Rahmen des Schrittes S27 aufgrund einer Verletzung des maximal zulässigen Gesamtenergiebezug Emax nachgeführt wird). Alternativ ist es möglich, der maximal zulässige Gesamtenergiebezug Emax von außen - beispielsweise vom Betreiber des elektrischen Versorgungsnetzes 5 - vorgegeben wird oder von der Steuereinrichtung 6 in Abhängigkeit von einer Netzauslastung N des elektrischen Versorgungsnetzes 5 variiert wird. In diesem Fall wird die Vorgehensweise von FIG 5 gemäß FIG 14 variiert.

Gemäß FIG 14 sind dem Schritt S1 Schritte S36 und S37 vorgeordnet. Im Schritt S36 ermittelt die Steuereinrichtung 6 eine Netzauslastung N. Die Steuereinrichtung 6 kann die Netzauslastung N beispielsweise anhand der Tages- und/oder Jahreszeit oder aufgrund einer messtechnischen Erfassung von Werten ermitteln, aus denen sich die Netzauslastung N ableiten lässt. Im Schritt S37 ermittelt die Steuereinrichtung 6 anhand der Netzauslastung N den maximal zulässigen Energiebezug Emax.

Zusammengefasst betrifft die vorliegende Erfindung somit folgenden Sachverhalt:

Eine Anlage der Grundstoffindustrie weist zumindest einen elektrischen Verbraucher 1, 2 von einem Typ 1 auf. Für Verbraucher 1, 2 vom Typ 1 sind jeweils mindestens drei Arbeitspunkte Aij definiert, denen jeweils ein zu erwartender Leistungsbezug PEij aus einem Versorgungsnetz 5 zugeordnet ist. Die Anlage der Grundstoffindustrie kann weiterhin elektrische Verbraucher 3, 4 von einem Typ 2 oder 3 aufweisen, für die entweder jeweils exakt zwei Arbeitspunkte Aij definiert sind, denen jeweils ein zu erwartender Leistungsbezug PEij aus dem Versorgungsnetz 5 zugeordnet ist, oder denen nur ein zu erwartender Leistungsbezug PEi aus dem Versorgungsnetz 5 zugeordnet ist. Fahrdiagramme für die Verbraucher 1 bis 3 vom Typ 1 und 2 - d.h. die Festlegung von deren Arbeitspunkten Aij als Funktion der Zeit t - werden unter Berücksichtigung technologischer Kriterien beim Betrieb der Anlage der Grundstoffindustrie derart bestimmt und unter Berücksichtigung des tatsächlichen Energiebezugs E1 kontinuierlich nachgeführt, so dass ein zwischen einem vorbestimmten Anfangszeitpunkt T1 und einem vorbestimmten Endzeitpunkt T2 erwarteter Gesamtenergiebezug E einen maximal zulässigen Gesamtenergiebezug Emax nicht übersteigt.

Die vorliegende Erfindung weist viele Vorteile auf. Insbesondere kann der maximal zulässige Energiebezug Emax nahezu vollständig ausgenutzt werden, wobei dennoch ein optimaler oder nahezu optimaler Betrieb der Anlage der Grundstoffindustrie erreicht werden kann. Die Produktivität der Anlage der Grundstoffindustrie kann optimiert werden, insbesondere dadurch, dass Standzeiten minimiert werden. In vielen Fällen können auch Verluste durch Abwärme minimiert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

**1.** Betriebsverfahren für eine Anlage der Grundstoffindustrie, die eine Anzahl elektrischer Verbraucher (1 bis 4) aufweist, die aus einem Versorgungsnetz (5) gespeist werden,

- wobei mindestens einer (1, 2) der Verbraucher (1 bis 4) von einem Typ 1 ist und die anderen (3, 4) Verbraucher (1 bis 4) vom Typ 1, von einem Typ 2 oder von einem Typ 3 sind,
- wobei für Verbraucher (1, 2, 3) vom Typ 1 und vom Typ 2 jeweils eine Anzahl von Arbeitspunkten (Aij) definiert ist,
- wobei den Arbeitspunkten (Aij) jeweils eine für den jeweiligen Arbeitspunkt (Aij) erwartete aus dem Versorgungsnetz (5) zu beziehende Leistung (PEij) zugeordnet ist,
- wobei die Anzahl an Arbeitspunkten (Aij) bei Verbrauchern (1, 2) vom Typ 1 mindestens drei und bei Verbrauchern (3) vom Typ 2 exakt zwei ist,
- wobei Verbrauchern (4) vom Typ 3 eine durchschnittliche erwartete aus dem Versorgungsnetz (5) zu beziehende Leistung (PEi) zugeordnet ist,
- wobei vor einem vorbestimmten Anfangszeitpunkt (T1) für die Verbraucher (1, 2, 3) vom Typ 1 und Typ 2 unter Berücksichtigung technologischer Kriterien beim Betrieb der Anlage der Grundstoffindustrie jeweils ein Fahrdiagramm bestimmt wird, das innerhalb eines Zeitfensters für jeden Zeitpunkt (t) den jeweiligen Arbeitspunkt (Aij) des jeweiligen Verbrauchers (1, 2, 3) festlegt,
- wobei das Zeitfenster sich zumindest von dem Anfangszeitpunkt (T1) zu einem vorbestimmten ersten Endzeitpunkt (T2) erstreckt,
- wobei die Fahrdiagramme für die Verbraucher (1, 2, 3) vom Typ 1 und Typ 2 derart bestimmt werden, dass zwischen dem Anfangszeitpunkt (T1) und dem ersten Endzeitpunkt (T2) ein anfänglicher Gesamtenergiebezug (E) erwartet wird, der einen maximal zulässigen Gesamtenergiebezug (Emax) nicht übersteigt,
- wobei während zwischen dem Anfangszeitpunkt (T1) und dem ersten Endzeitpunkt (T2) liegender tatsächlicher Zeitpunkte (t) jeweils ein momentan erwarteter Gesamtenergiebezug (E) ermittelt wird,
- wobei der jeweilige momentan erwartete Gesamtenergiebezug (E) sich durch die Summe der von den Verbrauchern (1 bis 4) vom Anfangszeitpunkt (T1) bis zum jeweiligen tatsächlichen Zeitpunkt (t) tatsächlich aus dem Versorgungsnetz (5) bezogenen, aufgrund von Messdaten (P, Pi, P4) ermittelten elektrischen Energie (E1) und einem für den Zeitraum von dem jeweiligen tatsächlichen Zeitpunkt (t) bis zum ersten Endzeitpunkt (T2) erwarteten Restenergiebezug (E2) ergibt,

- wobei der jeweilige erwartete Restenergiebezug (E2) sich durch die Fahrdiagramme für die Verbraucher (1, 2, 3) vom Typ 1 und Typ 2 vom jeweiligen tatsächlichen Zeitpunkt (t) zum ersten Endzeitpunkt (T2) und die durchschnittlichen erwarteten aus dem Versorgungsnetz (5) zu beziehenden Leistungen (PEi) der Verbraucher (4) vom Typ 3 ergibt,

- wobei der jeweilige erwartete Gesamtenergiebezug (E) mit dem maximal zulässigen Gesamtenergiebezug (Emax) verglichen wird,

- wobei in dem Fall, dass der jeweilige erwartete Gesamtenergiebezug (E) den maximal zulässigen Gesamtenergiebezug (Emax) übersteigt, unter Berücksichtigung der technologischen Kriterien beim Betrieb der Anlage der Grundstoffindustrie das Fahrdiagramm für mindestens einen Verbraucher (1, 2, 3) vom Typ 1 oder vom Typ 2 variiert wird und/oder mindestens einer der Verbraucher (4) vom Typ 3 abgeschaltet wird oder ein Einschalten mindestens eines Verbrauchers (4) vom Typ 3 unterdrückt wird, so dass der erwartete Gesamtenergiebezug (E) den maximal zulässigen Gesamtenergiebezug (Emax) nicht übersteigt.

2. Betriebsverfahren nach Anspruch 1, **dadurch gekennzeichnet, dass** der jeweilige erwartete Gesamtenergiebezug (E) mit einem minimalen Gesamtenergiebezug (Emin) verglichen wird und dass in dem Fall, dass der jeweilige erwartete Gesamtenergiebezug (E) den minimalen Gesamtenergiebezug (Emin) unterschreitet, unter Berücksichtigung der technologischen Kriterien beim Betrieb der Anlage der Grundstoffindustrie das Fahrdiagramm für mindestens einen Verbraucher (1, 2, 3) vom Typ 1 oder vom Typ 2 derart variiert wird und/oder mindestens einer der Verbraucher (4) vom Typ 3 eingeschaltet wird, so dass der erwartete Gesamtenergiebezug (E) dem maximal zulässigen Gesamtenergiebezug (Emax) angenähert wird.

3. Betriebsverfahren nach Anspruch 1 oder 2, **dadurch gekennzeichnet,**

- **dass** die Fahrdiagramme sich über den ersten Endzeitpunkt (T2) hinaus mindestens bis zu einem zweiten Endzeitpunkt (T3) erstrecken,

- **dass** eine zeitliche Differenz (T) zwischen dem zweiten Endzeitpunkt (T3) und dem ersten Endzeitpunkt (T2) gleich der zeitlichen Differenz (T) zwischen dem ersten Endzeitpunkt (T2) und dem Anfangszeitpunkt (T1) ist und

- **dass** im Rahmen der Ermittlung und der Variierung der Fahrdiagramme auch ein weiterer erwarteter Energiebedarf (E') berücksichtigt wird, der auf den Zeitraum zwischen dem ersten Endzeitpunkt (T2) und dem zweiten Endzeitpunkt (T3) bezogen ist.

4. Betriebsverfahren nach Anspruch 1, 2 oder 3, **dadurch gekennzeichnet, dass** in dem Fall, dass die zwischen dem Anfangszeitpunkt (T1) und dem ersten Endzeitpunkt (T2) tatsächlich bezogene Energie (E1) den maximal zulässigen Gesamtenergiebezug (Emax) übersteigt, der maximal zulässige Gesamtenergiebezug (Emax) zumindest für auf den ersten Endzeitpunkt (T1) folgende Zeiträume erhöht wird.

5. Betriebsverfahren nach einem der obigen Ansprüche, **dadurch gekennzeichnet, dass** den Verbrauchern (1, 2, 3) vom Typ 1 und vom Typ 2 statisch oder dynamisch jeweils eine hohe oder eine niedrige Prioritätsstufe (R) zugeordnet ist und dass beim Variieren der Fahrdiagramme vorrangig diejenigen Fahrdiagramme variiert werden, welche denjenigen Verbrauchern (1, 2, 3) vom Typ 1 und vom Typ 2 zugeordnet sind, denen momentan eine niedrige Prioritätsstufe (R) zugeordnet ist.

6. Betriebsverfahren nach einem der obigen Ansprüche, **dadurch gekennzeichnet, dass** die von den Verbrauchern (1, 2, 3) vom Typ 1 und vom Typ 2 tatsächlich aus dem Versorgungsnetz (5) bezogenen Leistungen (Pi) erfasst werden und dass die den Arbeitspunkten (Aij) zugeordneten erwarteten aus dem Versorgungsnetz (5) zu beziehenden Leistungen (PEij) anhand der tatsächlich aus dem Versorgungsnetz (5) bezogenen Leistungen (Pi) nachgeführt werden.

7. Betriebsverfahren nach einem der obigen Ansprüche, **dadurch gekennzeichnet, dass** die von den Verbrauchern (4) vom Typ 3 tatsächlich aus dem Versorgungsnetz (5) bezogenen Leistungen (P4) erfasst werden und dass die den Verbrauchern (4) vom Typ 3 zugeordneten erwarteten aus dem Versorgungsnetz (5) zu beziehenden Leistungen (PEi) anhand der tatsächlich aus dem Versorgungsnetz (5) bezogenen Leistungen (P4) nachgeführt werden.

8. Betriebsverfahren nach einem der obigen Ansprüche, **dadurch gekennzeichnet, dass** die Anlage der Grundstoffindustrie als Elektrostahlwerk ausgebildet ist, die als elektrischen Verbraucher (1, 2) vom Typ 1 einen Lichtbogenofen (1) und/oder einen Pfannenofen (2) aufweist, dass der elektrische Verbraucher (1, 2) vom Typ 1 aus dem Versorgungsnetz (5) gespeiste Elektroden (9, 10) aufweist und dass der Arbeitspunkt (Aij) eine Höheneinstellung der Elektroden (9, 10) über einem Badspiegel (15, 16) des Lichtbogenofens (1) oder Pfannenofens (2) umfasst.

9. Betriebsverfahren nach einem der obigen Ansprüche, **dadurch gekennzeichnet, dass** der maximal zulässige Gesamtenergiebezug (Emax) in Abhängigkeit von einer Netzauslastung (N) des elektrischen Versorgungsnetzes (5) variiert wird.

10. Computerprogramm, das Maschinencode (8) umfasst, der von einer Steuereinrichtung (6) für eine Anlage der Grundstoffindustrie abarbeitbar ist, wobei die Abarbeitung des Maschinencodes (8) durch die Steuereinrichtung (6) bewirkt, dass die Steuereinrichtung (6) die Anlage der Grundstoffindustrie gemäß einem Betriebsverfahren nach einem der obigen Ansprüche betreibt.

11. Steuereinrichtung für eine Anlage der Grundstoffindustrie, wobei die Steuereinrichtung mit einem Computerprogramm (7) nach Anspruch 10 programmiert ist, so dass die Steuereinrichtung die Anlage der Grundstoffindustrie gemäß einem Betriebsverfahren nach einem der Ansprüche 1 bis 9 betreibt.

12. Anlage der Grundstoffindustrie,

    - wobei die Anlage der Grundstoffindustrie eine Anzahl elektrischer Verbraucher (1 bis 4) aufweist, die aus einem Versorgungsnetz (5) gespeist werden,
    - wobei die Anlage der Grundstoffindustrie eine Steuereinrichtung (6) nach Anspruch 11 aufweist, welche die Anlage der Grundstoffindustrie gemäß einem Betriebsverfahren nach einem der Ansprüche 1 bis 9 betreibt.

13. Anlage der Grundstoffindustrie nach Anspruch 12, **dadurch gekennzeichnet, dass** die Anlage der Grundstoffindustrie als Elektrostahlwerk ausgebildet ist und dass die Anlage der Grundstoffindustrie als elektrischen Verbraucher (1, 2) vom Typ 1 einen Lichtbogenofen (1) und/oder einen Pfannenofen (2) aufweist.

# FIG 1

P1  17  3    P2  17    P3  17    P4  17  5

1    2    3    4

P1...P4

6    7
8

# FIG 2

| | | |
|---|---|---|
| 1 | A11<br>A12<br>A13<br>A14 | PE11<br>PE12<br>PE13<br>PE14 |
| 2 | A21<br>A22<br>A23<br>A24 | PE21<br>PE22<br>PE23<br>PE24 |
| 3 | A31<br>A32 | PE31<br>PE32 |
| 4 | ⁒ | PE4 |

FIG 3

FIG 4

## FIG 5

S1 — $Aij: E = \int_{T1}^{T2} \sum_i PEij\,(Aij\,(t))\,dt + PEi\cdot(T2-T1) \le Emax$

S2 — $t=0;\ E1=0$

S3 — T1?  —

+

S4 — $Aij\,(t)$

S5 — P

S6 — $t = t + \delta t$
$E1 = E1 + P \cdot \delta t$

S7 — T2?  —

+

STOP

S8 — $E2 = \int_t^{T2} \sum_i PEij\,(Aij\,(t))\,dt + PE\cdot(T2-t)$

$E = E1 + E2$ — S9

S10 — $E \le Emax?$  —

+

S11 — var

FIG 6

A1j

PE1j

T1

T2

t

FIG 7

PE2j

T1

A2j

T2

t

FIG 8

A3j

P3j

T1

T2

t

# FIG 9

S10 — E ≤ Emax?   —

+

S11 — var

S16 — E < Emin?   —

+

S17 — var

# FIG 10

START

$$S21 \quad Aij\!:\!E = \int_{T1}^{T2} \sum_i PEij \, (Aij \, (t)) \, dt + PEi \cdot (T2\text{-}T1) \leq Emax$$
$$E' = \int_{T2}^{T3} \sum_i PEij \, (Aij \, (t)) \, dt + PEi \cdot (T3\text{-}T2) \leq Emax$$

$$S2 \quad t = 0; \; E1 = 0$$

$$S3 \quad T1? \quad -$$

$+$

$$S4 \quad Aij \, (t)$$

$$S5 \quad P$$

$$S6 \quad t = t + \delta t$$
$$E1 = E1 + P \cdot \delta t$$

$$S7 \quad T2? \quad -$$

$+$

STOP

$$S22 \quad E2 = \int_{t}^{T2} \sum_i PEij \, (Aij \, (t)) \, dt + PE \cdot (T2\text{-}t)$$
$$\int_{T2}^{T3} \sum_i PEij \, (Aij \, (t)) \, dt + PEi \cdot (T3\text{-}T2) \leq Emax$$

$$E = E1 + E2 \quad S9$$

$$S10 \quad E \leq Emax? \quad -$$

$+$

$$S23 \quad var$$

## FIG 11

$$E2 = \int_t^{T2} \sum_i PEij\,(Aij\,(t))\,dt + PE\cdot(T2\text{-}t)$$

## FIG 12

| | | | |
|---|---|---|---|
| 1 | A11<br>A12<br>A13<br>A14 | PE11<br>PE12<br>PE13<br>PE14 | R=... |
| 2 | A21<br>A22<br>A23<br>A24 | PE21<br>PE22<br>PE23<br>PE24 | R=... |
| 3 | A31<br>A32 | PE31<br>PE32 | R=... |
| 4 | ... | PE4 | R=... |

## FIG 13

S4 — Aij (t)

S31 — P1 ··· P4

S32 — $t = t + \delta t$
$E1 = E1 + \delta t \sum Pi$

S33 — PEij (Aij) = f(PEij (Aij), Pi)

S34 — PEi = f(PEi, P4)

## FIG 14

START

S36 — N

S37 — Emax = Emax (N)

$$Aij: E = \int_{T1}^{T2} \sum_i PEij \, (Aij \, (t)) \, dt + PEi \cdot (T2-T1) \leq Emax$$

Europäisches Patentamt
European Patent Office
Office européen des brevets

## EUROPÄISCHER RECHERCHENBERICHT

**Nummer der Anmeldung**

EP 14 18 3226

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | VICO HAVERKAMP E: "Prädiktive dynamische Lastkontrolle für ein Elektrostahlwerk", STAHL UND EISEN, Bd. 128, Nr. 10, 2008, Seiten 61-68, XP001552539, * das ganze Dokument * | 1-13 | INV. G06Q10/06 ADD. G06Q50/06 H02J3/14 C21C5/52 |
| X | EP 0 913 905 A2 (VOSS GROSSKUECHENSYSTEME GMBH [DE]) 6. Mai 1999 (1999-05-06) * Zusammenfassung; Ansprüche 1-13; Abbildungen 1,2 * * Absätze [0022] - [0037] * | 1-13 | |
| X | EP 0 372 961 A2 (HONEYWELL INC [US]) 13. Juni 1990 (1990-06-13) * Zusammenfassung; Ansprüche 1-22; Abbildungen 1-6 * * Spalte 1, Zeile 4 - Spalte 17, Zeile 15 * | 1-13 | |
| A | "Maximum Demand Control Systems", , 31. Dezember 2006 (2006-12-31), XP055174578, Gefunden im Internet: URL:http://www.measurlogic.com/EnergyManagement/Resources/MaxDemandBook_1oM6.pdf [gefunden am 2015-03-06] * das ganze Dokument * | 1-13 | **RECHERCHIERTE SACHGEBIETE (IPC)** G06Q H02J C21C |

-/--

Der vorliegende Recherchenbericht wurde für alle Patentansprüche erstellt

| Recherchenort | Abschlußdatum der Recherche | Prüfer |
|---|---|---|
| Den Haag | 12. März 2015 | Streit, Stefan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**
**European Patent Office**
**Office européen des brevets**

# EUROPÄISCHER RECHERCHENBERICHT

**Nummer der Anmeldung**

EP 14 18 3226

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | "Zukunftsorientiertes Lastmanagement optimiert Energiekosten Sonderdruck 2011", Metering Automation, 31. Dezember 2011 (2011-12-31), XP055174580, Gefunden im Internet: URL:http://www.berg-energie.de/uploads/pics/pdfs/BHS/Berg_Sonderdruck-Lastmanagement_2011.pdf [gefunden am 2015-03-06] * das ganze Dokument * ----- | 1-13 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 12. März 2015 | Streit, Stefan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

## ANHANG ZUM EUROPÄISCHEN RECHERCHENBERICHT
## ÜBER DIE EUROPÄISCHE PATENTANMELDUNG NR.

EP 14 18 3226

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-03-2015

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 0913905 | A2 | 06-05-1999 | DE | 19748330 | A1 | 12-05-1999 |
|  |  |  | EP | 0913905 | A2 | 06-05-1999 |
| EP 0372961 | A2 | 13-06-1990 | AU | 621426 | B2 | 12-03-1992 |
|  |  |  | AU | 4605989 | A | 14-06-1990 |
|  |  |  | CA | 2004836 | A1 | 08-06-1990 |
|  |  |  | EP | 0372961 | A2 | 13-06-1990 |
|  |  |  | JP | H03117322 | A | 20-05-1991 |
|  |  |  | US | 4916328 | A | 10-04-1990 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **VICO HAVERKAMP et al.** Prädiktive dynamische Lastkontrolle für ein Elektrostahlwerk. *stahl und eisen,* 2008, vol. 128 (10), 61-68